# EUROPEAN PATENT SPECIFICATION

(11) **EP 0 178 447 B1**
(45) Date of publication and mention of the grant of the patent: **17.02.1993**
(21) Application number: 85111301.9
(22) Date of filing: 06.09.1985
(51) Int. Cl.: H01L 21/20, H01L 21/268

(54) **A manufacturing method of an integrated circuit based on semiconductor-on-insulator technology**
Verfahren zur Herstellung einer auf der Halbleiter-auf-Isolator-Technologie basierenden integrierten Schaltung
Une méthode de fabrication d'un circuit intégré basé sur la technologie semi-conducteur sur isolant

(30) Priority: 09.10.1984 JP 211703/84; 17.01.1985 JP 6221/84
(43) Date of publication of application: 23.04.1986
(73) Proprietor: FUJITSU LIMITED, Kawasaki-shi, Kanagawa 211 (JP)
(72) Inventor: Mukai, Ryoichi, Kawasaki-shi Kanagawa, 213 (JP)
(74) Representative: Schmidt-Evers, Jürgen, Dipl.-Ing.

(56) References cited:
- EP-A- 0 047 140
- PATENT ABSTRACTS OF JAPAN, vol. 7, no. 88 (E-170)[1233], 12th April 1983; & JP-A-58 14 524
- JOURNAL OF APPLIED PHYSICS, vol. 55, no. 6, part 1, 15th March 1984, pages 1607-1609, American Institute of Physics, New York, US; S. KAWAMURA et al.: "Laser recrystallization of Si over SiO2 with a heat-sink structure"
- IEEE ELECTRON DEVICE LETTERS, vol. EDL-4, no. 10, October 1983, pages 366-368, IEEE, New York, US; S. KAWAMURA et al.: "Three-dimensional CMOS IC's fabricated by using beam recrystallization"
- ELECTRONICS LETTERS, vol. 19, no. 1, 6th January 1983, pages 12-14, London, GB; D. HERBST et al.: "PMOS transistors fabricated in large-area laser-crystallised Si on silica"
- APPLIED PHYSICS LETTERS, vol. 41, no. 4, 15th August 1982, pages 346-347, American Institute of Physics, New York, US; J.P. COLINGE et al.: "Use of selective annealing for growing very large grain silicon on insulator films"
- ELECTRONICS INTERNATIONAL, vol. 55, no. 9, 5th May 1982, pages 74-76, New York, US; R.T. GALLAGHER: "Selective laser annealing opens the door to stacked-transistor C-MOS technology"

## Description

### BACKGROUND OF THE INVENTION

The present invention relates to a method of fabricating at least an active region of a semiconductor device based on so-called SOI (semiconductor on insulator) technology, particularly by using an antireflection film for laser beam irradiation.

SOI technology has been receiving increasing interest because of its attractive capabilities of providing integrated circuits (ICs) with increased breakdown voltages between isolated circuit components such as transistors and so forth, and also with improved operating speeds due to reduced parasitic capacitances between the circuit components and a substrate the circuit components formed thereon. The outstanding feature of SOI technology is the capability of providing three-dimensional ICs considered as the most promising means of breakthrough for the limitation to the integration density in conventional ICs.

In the early stage of SOI technology, efforts were directed to obtaining a recrystallized zone as large as possible in a polycrystalline semiconductor layer such as a polysilicon layer. This resulted in the difficulty of forming a grain boundary free zone at a desired position in the semiconductor layer. If a grain boundary locates in the active region of a transistor, for example, formed in the recrystallized zone, characteristics of the transistor cannot be comparable to ordinary transistors fabricated on single crystal silicon substrates. Such grain boundary becomes the causes of increased leakage currents and nonuniformity of threshold voltages of the transistors.

Recent development in the SOI technology rather seems to be concentrated to selective recrystallization of an amorphous or polycrystalline semiconductor layer. That is, only predetermined zones of a semiconductor layer, in each of which an active component such as transistor is to be formed, are recrystallized into single crystal islands. Though originally proposed for increasing efficiency of the light beam irradiation for recrystallizing a semiconductor layer, antireflection film coating has been reported to be advantageous for such selective recrystallization if it is modified into a stripe structure. (Colinge et al; Applied Physics Letters, vol.41, p.346, 1982). In this method, transversely arranged stripes of antireflection film are formed on a amorphous or polycrystalline silicon layer. A laser beam having diameter large enough to cover at least two adjacent stripes is scanned along the center line between the stripes. The laser beam energy is controlled to be at slightly above the lowest level necessary for melting the uncoated zone of the silicon layer. Thus, a desired concaved temperature profile in the lateral direction can be achieved thanks to the greater beam absorption by the stripes of antireflection film. This method will be described in some detail in the following.

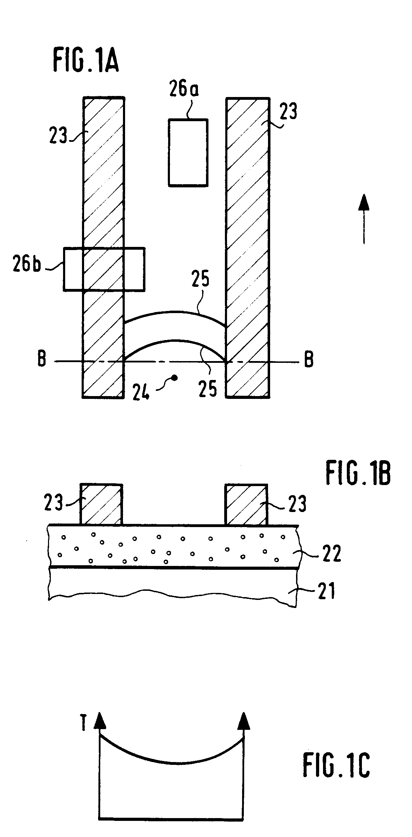

FIGs.1(a) and 1(b) are schematic illustrations of an amorphous or polycrystalline silicon layer and stripe-structured antireflection films successively formed on an amorphous insulating layer, wherein FIG.1(a) is a plan view and FIG.1(b) is a cross-section taken along the line B-B in FIG.1(a).

Referring to FIG.1(a) and 1(b), an amorphous or polycrystalline silicon layer 22, which is to be recrystallized into a single crystal, is deposited on an amorphous insulating layer 21. An antireflection film of silicon nitride, Si₃N₄, is formed on the silicon layer 22, and then, delineated into stripe structures 23 as shown in FIGs.1(a) and 1(b). If thickness of the antireflection film stripes 23 is adequately controlled, the reflectivity of the surface of the silicon layer 22 at the region coated with the stripe 23 can approximately be 5% in contrast to that of 60% at the uncoated region. As a result, when a irradiation or laser beam, an argon ion laser beam, for example, having a spot diameter larger than the distance between the stripes 23 is applied, temperature distribution profile as shown in FIG.1(c) is obtained in the lateral direction (i.e. the direction along B-B line in FIG.1(a)). In FIG.1(c), ordinate indicates temperature T and abscissa indicates the position between the stripes 23. As shown in FIG.1(c), the temperature T is lowest at the center of the stripes 23.

When a laser beam is scanned along the center line between the stripes 23 in the direction as indicated by the arrow in FIG.1(a), recrystallization front edges in the silicon layer is schematically indicated by a curve 25 which moves upward according to the scanning of the laser beam. In FIG.1(a), two curves 25 correspond to respective recrystallization fronts at two different moments. Each of the curves 25 indicates a solid-liquid interface and melting point of the silicon layer 22 distributes along the curve 25. Because the curve 25 (solid-liquid interface line) has curvature bending behind the front edge, the growth of a crystal grain nucleated from a virtual seed on the center line is dominant, and finally, spreads over the region between the stripes 23. As a result, grain boundaries between the above mentioned dominant grain and other subdominant grains are going to be swept from the region between the stripes 23 and accumulate under the stripes 23. Similar concaved temperature profile is obtained by using a doughnut-shaped laser beam and successful recrystallization is achieved in a polysilicon layer on an amorphous layer. (Kawamura et al; Applied Physics Letters, vol.40, p.394, 1982)

Thus, with the use of antireflection film stripes, it is reported that a single crystallized zone of 20x100 µm² (square microns) can be formed in a silicon layer on an amorphous insulating layer. The stripe-structured antireflection film permits laser beam to be efficient and simple of its shape as a round beam. However, the stripe-structured antireflection film methodology inevitably decreases the freedom in the device pattern layout on a semiconductor layer.

Referring to FIGs.1(a) and 1(b), if devices such as transistors or at least active regions of the devices are respectively located in zones 26a and 26b of the semiconductor layer 22, one of the devices or active regions of the devices can be formed in a single-crystallized zone 26a, but another formed in a zone 26b can not be free of a grain boundary because of the reason as described before. Since grain boundaries provide the device with the aforesaid undesirable influences, the device pattern layout can not but be restricted within the zone between the antireflection film stripes 23. This means that random layout of the devices or active regions of the devices is substantially inhibited and the devices or the active regions must be positioned in a relatively orderly arrangement instead. As a result, SOI technology using antireflection film stripes is suitable to integrated circuits (ICs) such as those based on gate array methodology but is rather not suitable to ICs requiring random arrangement of devices as in logic ICs. Thus, the anti-reflection film stripe methodology also restricts efficient use of semiconductor area in ICs based on SOI.

Further prior art is disclosed by:
1) The Patent Abstracts, Vol. 7, No. 88 (1983) E-170 (1233) shows a structure which has an opening in an antireflection SiO₂-film formed at a non-crystalline Si-island, which was formed by patterning the non-crystalline Si-layer on the SiO₂ film. First a non-crystalline Si-island is formed and after forming an antireflection film on this non-crystalline Si-island then this whole island is recrystallized into a single crystal.
2) From the Journal of Applied Physics, Vol. 55, part 1 (1984), pp 1607-1609 it is know forming an insulating layer on an existing recrystallized area and depositing a gate electrode on this insulating layer.
3) The IEEE Device Lett. Vol. EDL4, No. 10 (1983) pp 366-368 indicates that multiple layer antireflecting coatings are known in the field of recystallization of semiconductors. In particular, on page 367 layers of silicon dioxide, silicon nitride and PSG are deposited to from the antireflection coating.
4) The "Electronics International" Vol. 55, No. 9 (1982) pp 74-76 teaches that in a selected transistor structure it is necessary only to anneal or recrystallize the semiconductor material that will become the channel for the second layer transistors (page 74).

### SUMMARY OF THE INVENTION

It is an object of the present invention to provide a method for fabricating a special semiconductor integrated circuit device based on a principle of SOI technology using an antireflection film and performing recrystallization by light beam irradiation, wherein the layout of such devices on a semiconductor layer can be substantially random and wherein effective use of unrecrystallized semiconductor areas is achieved.

It is further an object of the present invention to provide insulated-gate transistors based on said technology but with improved fabrication yield of the device.

The above objects can be achieved by fabricating semiconductor integrated circuit elements using an antireflection layer patterned with openings but not in the form of stripes. The fabrication method comprising steps of: (a) forming an amorphous or polycrystalline semiconductor layer on an amorphous insulating layer; (b) forming an antireflection film to a light beam on the semiconductor layer; (c) selectively forming openings at respective portions of the antireflection film, the location of said openings being predetermined by the layout of said device; (d) irradiating the light beam to an area of the surface of the antireflection film, this area including at least one of the openings, on condition that the semiconductor layer is recrystallized to be free of grain boundaries at the opening; and (e) forming a semiconductor device element or active region of the device in the recrystallized semiconductor layer zone at the opening, the surrounding semiconductor material which contains the inevitable wiring of the device being left polycrystalline. In accordance with this method, the channel region of an insulated-gate field effect transistor (IG-FET) or metal oxide semiconductor (MOS) transistor is exclusively formed in such a recrystallized semiconductor layer zone at the opening, and source and drain and its connections are part of the remaining polycrystalline portion of the semiconductor layer.

### BRIEF DESCRIPTION OF DRAWINGS

The above and other objects and advantages of the present invention will become apparent from the following description of embodiments with reference to accompanying drawings forming a part thereof, wherein:
Figs. 1(a) and 1(b) are schematic illustrations of an amorphous or polycrystalline silicon layer formed on an amorphous insulating layer and stripes of anti-reflection layer formed on the silicon layer, wherein Fig. 1(a) is a plan view and Fig. 1(b) is a cross-section taken along the line B-B in Fig. 1(a);
Fig. 1(c) is a temperature distribution profile obtained in the direction along B-B line in Fig. 1(a);
Figs. 2(a) and 2(b) are a plan view and enlarged cross-section taken along line B-B in Fig. 2(a) in accordance with an embodiment of the present invention.
FIG.3(a) is a plan view schematically illustrating the growth of single recrystallized zone at an opening according to the present invention;
FIGs.3(b) and 3(c) are respective temperature distribution profiles on the lines E-E and F-F in FIG.3(a);
FIGs.4(a) to 4(g) are cross-sections at the respective fabrication steps of a semiconductor device based on an SOI technology; and
FIGs.5(a) to 5(d) show yet another embodiment of the present invention.

### DETAILED DESCRIPTION OF PREFERRED EMBODIMENTS

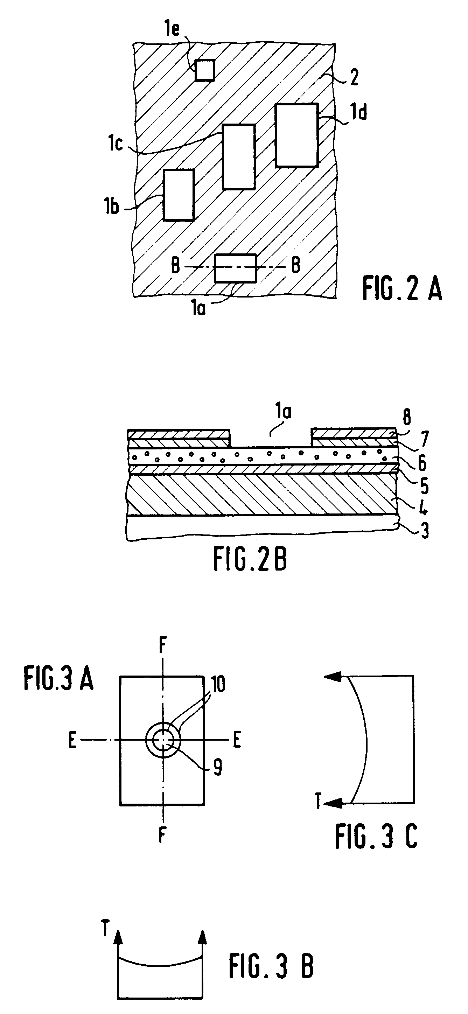

An embodiment of the present invention is shown in a plan view of FIG.2(a) and an enlarged cross-section of FIG.2(b) taken along line B-B in FIG.2(b). Referring first to FIG.2(b), as a substrate, an insulating layer of SiO₂ layer 4 of thickness of about 1 µm (micron) is formed on a silicon wafer 3 by using a thermal oxidation process, for example. Respective one of silicon nitride layer 5 and polysilicon layer 6 having thicknesses of 100 nm (1000 Å) and 400 nm (4000 Å), respectively, are successively formed on the SiO₂ layer 4 by using low pressure chemical vapor deposition (LPCVD) methods, for example. The polysilicon layer 6 is the layer to be subject to a recrystallization process later, and the silicon nitride layer 5 is for improving adhesion of the polysilicon layer 6 to the SiO₂ layer 4 after the recrystallization. A SiO₂ layer 7 of about 30 nm (300 Å) is formed by thermally oxidizing the surface of the polysilicon layer 6 and then a silicon nitride layer 8 of about 30 nm (300 Å)is deposited thereon by using an LPCVD method, for example. The SiO₂ layer 7 and silicon nitride layer 8 constitute antireflection film 2 in FIG.2(a). The thickness of the antireflection film 2 is determined according to the wave length of laser beam for the recrystallization and the refractive index of the layer materials to the wave length. The antireflection film may comprises a single layer of either of SiO₂ or silicon nitride, however, the double-layered structure of the antireflection film allows to take advantages as described in later.

Referring back to FIG.2(a), the antireflection film 2 is provided with according to this embodiment of the invention, substantially rectangular-shaped openings (windows) 1a, 1b, 1c and so forth, instead of being formed into the stripe structure in the prior art as shown in FIGs.1(a) and 1(b). Each of the openings is positioned so as to correspond to a device zone (the zone in which a device such as transistor or the active region such as channel region of the transistor is formed). The dimension of the opening is 10 to 20 µm (microns), for example.

A light beam from a cw (continuous wave) Ar ion laser, for example, having output power of 8 to 14 watts is scanned over the antireflection film 2 and the polysilicon layer at the openings 1a, 1b, 1c and so forth at a speed of 5 cm/sec. The scan of the laser beam is carried out by translating the wafer 3 relative to a fixed beam or it may be done vice versa, wherein scanning pitch is controlled to be smaller than the diameter of the beam D so that the traces of the scanned beam overlap each other. A preferable overlap ratio is approximately 70 per cent of the beam diameter. The beam diameter D is 80 to 100 µm (microns) in terms of the width of irradiated area on the substrate. The dimension of an opening is 10 to 20 µm (microns) as mentioned before. Hence, since the beam is relatively larger than the openings (4 to 10 times) and the scanning speed is relatively high compared with the dimension of openings, the polysilicon layer at each opening can be assumed to be heated with a pulse of a fixed beam. In the above, the beam for the recrystallization should not be limited to a laser beam but other energy beam such as a focused emission of a mercury lamp may be employed if it can provide a sufficient energy density.

FIG.3(a) is a plan view schematically illustrating the growth of single recrystallized zone in an opening, for example, the opening 1a in FIg.2(a). FIGs.3(b) and 3(c) are temperature distribution profiles along the lines E-E and F-F in FIG.3(a), respectively, wherein T indicates temperature and coordinates on the respective axes perpendicular to the temperature axes indicate the position on lines E-E and F-F. The same as in the prior art using stripe-structured antireflection film 2 as described with reference to FIGs.1(a) to 1(c), the temperature T is lowest at the center of the opening 1a in both E-E and F-F directions and increases toward the periphery of the opening 1a because of the greater absorption of the laser beam irradiation by the antireflection film 2. As a result, recrystallization of the polysilicon layer initiates from the nucleus 9 at the center of the opening immediately after the cease of the pulsed laser beam irradiation. A substantially isotropic recrystallization occurs to spread as shown by circles 10 in FIG.1(a), and finally, fills in the opening 1a. Thus, a grain-boundary-free single crystal silicon layer zone is formed in the opening 1a, and similarly in other openings.

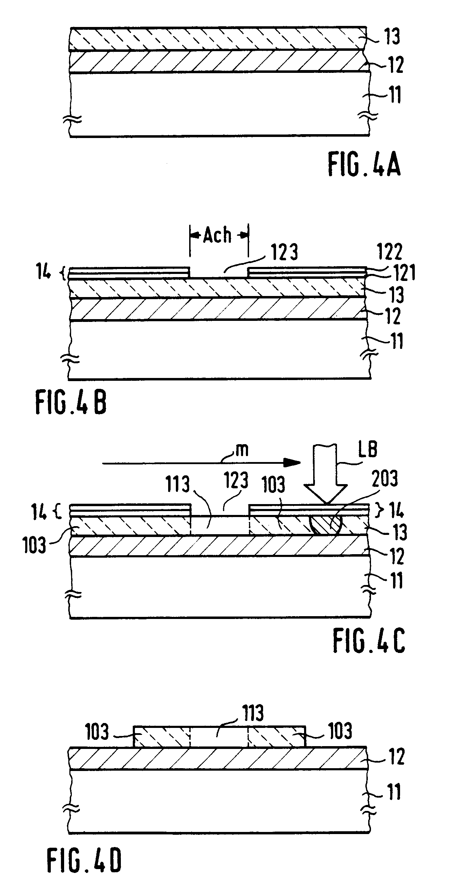

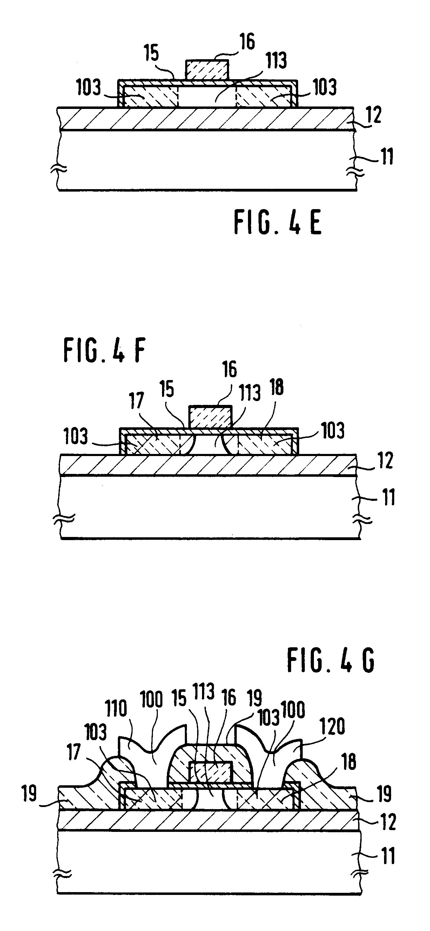

Another embodiment of the present invention will be described in the following with reference to FIGs.4(a) to 4(g) illustrating cross-sections at the respective fabrication steps of a semiconductor device based on SOI technology.

Referring to FIG.4(a), a SiO₂ insulating layer 12 of thickness of about 1 micron is formed on a silicon substrate 11 by using a thermal oxidation process, and then, an amorphous or polycrystalline silicon layer 13 of thickness of about 400 nm (4000 Å) is deposited on the insulating layer 12 by using a CVD (chemical vapor deposition) method. In the following description of this embodiment, a polysilicon layer stands for the silicon layer 13. The polysilicon layer 13 is then doped with a predetermined concentration of boron, B, as a p-type impurity by an ion implantation technique. Thus, the polysilicon layer 13 is provided with p-type conductivity.

A SiO₂ thin layer 121 of thickness of about 30 nm (300 Å) is formed on the polysilicon layer 13 by using a thermal oxidation process, and then a silicon nitride (Si₃N₄) layer 122 of thickness of about 30 nm (300 Å) is deposited on the SiO₂ film 121 by a CVD method. The SiO₂ layer 121 and Si₃N₄ layer 122 are selectively removed as shown in FIG.4(b) by using a conventional photolithographic technique so that openings throughout the layers are formed at predetermined regions Ach. Each of the regions is referred to as device region in which an insulated gate field effect transistor (IG-FET) or at least the channel of the transistor is to be formed. In FIG.4(b), only one opening 123 is illustrated.

The SiO₂ layer 121 and Si₃N₄ layer 122 constitutes an antireflection film 14 to the laser beam irradiation. The antireflection film may comprise either one of SiO₂ or Si₃N₄ layer as mentioned before, however, the double-layered antireflection film 14 as shown in FIG.4(C) permit to take advantage of large etching rate difference between SiO₂ and Si₃N₄ or silicon to etchants such as carbon tetra-fluoride (CF₄) gas and a hydrochloric acid (HF) solution. For instance, during a dry etching process for forming the opening 123, the SiO₂ layer 121 having a relatively low etching rate compared with those of the Si₃N₄ layer 122 and polysilicon layer 13 plays a role of a stopping layer against the etching by an etchant gas such as CF₄ but it can easily be removed by HF solution without affecting the polysilicon layer 13. Thus, the process for forming precision openings 123 in the antireflection film on the polysilicon layer 123 can be facilitated.

During the substrate 11 is heated at about 450°C in atmospheric air, scan of a laser beam LB, Ar ion laser, for example, in the direction of an arrow m is applied to the polysilicon layer 13 through the antireflection film 14 as shown in FIG.4(c). Hence, every portions of the polysilicon layer 13 are brought into a molten state once according to the scan of the laser beam, and its corresponding zone 113, to the opening 123 is recrystallized into a single crystal. In FIG.4(c), references 103 and 203 designate a domain recrystallized into a polycrystalline state and that in molten state, respectively.

Intensity and scanning speed of the laser beam LB are controlled to be enough for melting the polysilicon layer 13 under the antireflection film 14 which decreases the reflectivity of the surface of the polysilicon layer 13 to about 5 per cent but insufficient for melting a polysilicon layer alone having surface reflectivity of about 60 per cent alone. (i.e. the laser beam is too week to raise the polysilicon layer 13 at the opening 123 up to the melting point if no antireflection film 14 is formed around the opening 123.) Exemplary conditions complying with such requirement are as follows:
Laser output: 10 Watts
Laser beam diameter: 50 µm (microns)
Scanning speed: 5 cm/s
In the above, the laser beam diameter is defined in terms of the width of the melted zone of a polycrystalline layer coated with an antireflection film when a laser beam is scanned thereon.

With the scan of a laser beam under the above conditions, recrystallization of the polysilicon layer 13 initiates at the center of the opening 123 and spreads therein as explained with reference to FIG.3 (a). Thus, the polysilicon layer 13 at the opening 123 becomes single-crystalized, however, desirable recrystallization into a single crystal layer zone does not occur in the circumferential polysilicon layer 13 under the antireflection film 14 as mentioned before.

In accordance with the object of the present invention, a number of openings in an antireflection film can be positioned randomly, corresponding to the zones, each for forming a device or an active region of the device therein. As a result, it is probable that when a laser beam is scanned with aforesaid overlapping manner, the edge of the laser beam occasionally crosses over an opening at which the polysilicon layer has already been single-crystallized. However, the single-crystallized zone would not be melted again by the laser beam scan, because heat necessary for the single-crystallized zone to reach again its melting point is not supplied from the un-irradiated side region of the opening.

After the polysilicon layer 13 at each opening 123 is recrystallized to be grain boundary free (whereas each corresponding circumferential region is recrystallized as a polycrystalline layer), the Si₃N₄ layer 122 and SiO₂ layer 121 constituting the antireflection film 14 are removed by using a hot phosphoric acid solution and a hydrofluoric acid solution, respectively. Then, the polysilicon layer 13 is formed into islands so that each island includes one of the single-crystallized zone 113 and corresponding polycrystalline circumferential region 103, as shown in FIG.4(d).

The surface of the island is thermally oxidized, hence a gate oxide layer 15 having a predetermined thickness is formed as shown in FIG.4(e). Subsequently, a polysilicon layer of thickness of about 400 nm (4000 Å) is formed on the island by a conventional CVD process and selectively etched by using an ordinary photolithographic technique so that a gate electrode 16 is left on the single-crystallized zone 113.

Following the above, high concentration of an impurity such as arsenic (As) is ion-implanted into the silicon layer 103 with the use of polysilicon gate electrode 16 as a mask, hence n⁺-type source or drain regions 17 and 18 are formed after an annealing at temperature 1050°C, as shown in FIG.4(f). Thus, basic structure of an insulated-gate field effect transistor (IG-FET) or MOS transistor is completed based on SOI technology.

An insulating coating layer 19 is formed on each of the transistor structure. The insulating coating layer 19 having thickness of about 800 nm (8000 Å) is, then, provided with contact holes 100 through which connections to the source or drain regions 17 and 18 are provided by the respective wiring layers 110 and 120 of aluminum, for example, as shown in FIG.(g). If a PSG (phospho-silicate glass) layer is used for the insulating coating layer 19, a heat process (conventionally referred to as a reflow process) at 1050°C, for example, is needed for blunting the sharp edge of the contact holes 100.

As described above, a heat process at a temperature as high as 1050°C is necessary for the annealing of the ion-implanted source or drain regions 17 and 18 or the reflow process for the contact holes 100 in a PSG layer. The heat process at such high temperature tends to cause diffusion of doped impurities from the source or drain regions 17 and 18 to the single crystal zone 113. If a grain boundary should exist in the single crystal zone 113, the impurity diffusion along the grain boundary would be accelerated, and thus, the problems in the prior art, such as increased leak currents, non-uniform threshold voltages, source-drain breakdown failures, etc. in the devices formed in the recrystallized semiconductor layer zone would occur.

Again, in the prior art SOI technology using antireflection film, it is substantially impossible to recrystallize a semiconductor layer selectively only at the device regions. As a result, the zones to be grain boundary free are formed inevitably large in order to provide some degree of freedom in the arrangement of the devices. This results in difficulty in the fabrication and poor yield of semiconductor integrated circuits based on the SOI technology. On the other hand, according to the present invention, it is possible to recrystallize a semiconductor layer at arbitrary zones corresponding to the device regions, as explained in the above embodiments. As a result, small semiconductor, zones, each of which afford to accommodate at least the active region of a device, for example, a channel region of an IG-FET, can selectively be grain boundary free, corresponding to the device layout. Thus, according to the present invention, the IG-FETs, for example, in a semiconductor integrated circuit based on an SOI technology can be free from the prior art problems relating to the grain boundaries, and therefore, superior characteristics and greater fabrication yield of the integrated circuit can also be provided. It is obvious that the entire region of a device including the source or drain regions of an IG-FET, for example, can be fabricated in a grain-boundary-free zone formed according to the present invention, since the grain-boundary-free zone can be large as 10x20 µm² (square microns)

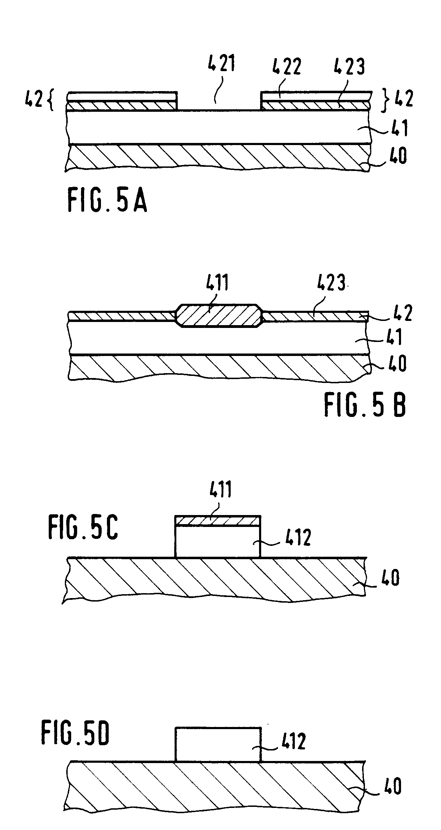

FIGs.5(a) to 5(d) show further another embodiment of the present invention. A polycrystalline semiconductor layer 41, polysilicon layer, for example, having thickness of about 400 nm (4000 Å) is formed on an insulating layer 40 having thickness of about 1 µm (micron), and an antireflection film 42 having an opening 421 is formed on the polysilicon layer 41, as shown in FIG.5(a). The antireflection film 42 may has a double-layered structure comprising a Si₃N₄ layer 422 and an underlying SiO₂ layer 423, each having a thickness of about 30 nm (300 Å). The polysilicon layer 41 at the opening 421 is recrystallized to be grain boundary free by a laser beam irradiation, as described in the previous embodiments. The surface of the polysilicon layer 41 at the opening 421 is thermally oxidized to form a SiO₂ layer 411 of thickness of about 100 nm (1000 Å). The antireflection film 42 protects the polysilicon layer 41 around the opening 421 from the thermal oxidation.

The Si₃N₄ layer 422 of the antireflecting film 42 is removed by using a selective etchant such hot phosphoric acid solution. The SiO₂ layer 411 and the exposed SiO₂ layer 423 as shown in FIG.5(b) are subjected to a dry etching process using an etchant such as CF₄ plasma. The time necessary for etching off the 30 nm (300 Å)SiO₂ 423 is about 40 seconds and that for the 100 nm (1000 Å)SiO₂ layer 411 is about 120 seconds. Hence, the surface of the polysilicon layer 41 around the opening 421 is first exposed to the CF₄ plasma, and subsequently etched off completely before the remaining about 70 nm (700 Å)SiO₂ layer 411 is etched off, as shown in FIG.5(c), because etch rate of silicon by CF₄ plasma is about 100 times larger than that of SiO₂. The dry etching is continued until the SiO₂ layer 411 is just removed, and finally, a single crystal island 412 of silicon is left on the insulating layer 40, as shown in FIG.5(d). Thus, self-aligned single crystal silicon islands can be obtained in accordance with the SOI technology of the present invention.

## Claims

1. A fabrication method of a single crystal semiconductor device in a polycrystalline or amorphous semiconductor layer, comprising the steps of:
forming an amorphous or polycrystalline semiconductor layer (13) on an amorphous insulating layer (12);
forming an unpatterned antireflection film (14) for a given light beam over said semiconductor layer (13);
selectively forming openings (123) at predetermined positions on said antireflection film (14);
irradiating an area of the surface of said antireflection film (14) with said light beam, said area including a least one of said openings (123), so that said semiconductor layer (13) is recrystallised to be free of grain boundaries in said opening (123), while remaining other portions of said semiconductor layer (13) are left polycrystalline or amorphous;
forming the active region of said semiconductor device in the recrystallized semiconductor layer in said opening (123); and
forming source and drain regions (17,18) of said semiconductor device abutting said recrystallized region in said remaining other portions of said semiconductor layer (13), said source and drain regions facing each other across said recrystallized region.

2. A fabrication method of a semiconductor as set forth in claim 1, wherein said semiconductor is silicon.

3. A fabrication method of a semiconductor device as set forth in claim 2, wherein said insulating layer (12) is a silicon dioxide layer.

4. A fabrication method of a semiconductor device as set forth in anyone of the claims 1 to 5, wherein said antireflection film (14) comprises a silicon nitride layer (122) .

5. A fabrication method of a semiconductor device as set forth in claim 6, wherein said antireflection film (14) further comprises an underlying silicon dioxide layer (121).

6. A fabrication method of a semiconductor device as set forth in anyone of the claims 1 to 7, wherein said light beam is a laser beam.

7. A fabrication method of a semiconductor device as set forth in claim 8, wherein said laser beam is an Ar ion laser beam.

8. A fabrication method of a semiconductor device as set forth in claim 1, wherein said light seam is scanned over said antireflection film (14) so that semiconductor regions at said openings (123) are consecutively recrystallized.

9. A fabrication method of a semiconductor device as set forth in anyone of the claims 1 to 8, further comprising a step of forming an insulated gate electrode on said recrystallized region comprising a gate electrode (16) and a further insulating layer (15) formed between said gate electrode and said recrystallized region.

10. A fabrication method of a semiconductor device as set forth in claim 9, wherein said further insulating layer (15) is a silicon dioxide layer formed by using LPCVD (low pressure chemical vapor deposition).

11. A fabrication method of a semiconductor device as set forth in claim 9, wherein said further insulating layer (15) is a silicon dioxide layer formed by thermally oxidizing the surface of said recrystallized zone of said semiconductor layer (13).

## Patentansprüche

1. Herstellungsverfahren für eine Einkristall-Halbleitervorrichtung in einer polykristallinen oder amorphen Halbleiterschicht, mit den Verfahrensschritten:
- Erzeugen einer amorphen oder polykristallinen Halbleiterschicht (13) auf einer amorphen, isolierenden Schicht (12);
- Erzeugen eines nichtstrukturierten, für einen vorgegebenen Lichtstrahl nichtreflektierenden Films (14) über diese Halbleiterschicht (13) hinweg;
- Selektives Erzeugen von Öffnungen (123) an vorgegebenen Stellen dieses nichtreflektierenden Films (14);
- Bestrahlen eines Flächenbereichs der Oberfläche dieses nichtreflektierenden Films (14) mit dem Lichtstrahl,
- wobei dieser Flächenbereich wenigstens eine dieser Öffnungen (123) einschließt, so daß die Halbleiterschicht (13) in dieser Öffnung (123) frei von Korngrenzen rekristallisiert, wohingegen übrige andere Anteile dieser Halbleiterschicht (13) polykristallin oder amorph bleiben;
- Erzeugen des aktiven Bereichs dieser Halbleitervorrichtung in der rekristallisierten Halbleiterschicht innerhalb dieser Öffnung (123); und
- Erzeugen von Source- und Drainbereichen (17, 18) dieser Halbleitervorrichtung, angrenzend an diese rekristallisierte Zone in diesen übrigen anderen Anteilen dieser Halbleiterschicht (13), wobei die Source- und Drainbereiche über diese rekristallisierte Zone hinweg einander gegenüberliegend sind.

2. Herstellungsverfahren nach Anspruch 1,
bei dem dieser Halbleiter Silizium ist.

3. Herstellungsverfahren nach Anspruch 2,
bei dem diese isolierende Schicht (12) eine Siliziumdioxid-Schicht ist.

4. Herstellungsverfahren nach einem der Ansprüche 1 bis 3,
bei dem dieser nichtreflektierende Film (14) eine Siliziumnitrid-Schicht (122) umfaßt.

5. Herstellungsverfahren nach Anspruch 4,
bei dem dieser nichtreflektierende Film (14) außerdem eine darunterliegende Siliziumdioxid-Schicht (121) umfaßt.

6. Herstellungsverfahren nach einem der Ansprüche 1 bis 5,
bei dem dieser Lichtstrahl ein Laserstrahl ist.

7. Herstellungsverfahren nach Anspruch 6,
bei dem dieser Laserstrahl der Strahl eines Argonionenlasers ist.

8. Herstellungsverfahren nach Anspruch 1,
bei dem man diesen Lichtstrahl über den nichtreflektierenden Film (14) derart hinweglenkt, so daß in diesen Öffnungen (123) Halbleiterbereiche aufeinanderfolgend rekristallisieren.

9. Herstellungsverfahren nach einem der Ansprüche 1 bis 8,
mit dem weiteren Verfahrensschritt des Herstellens einer isolierten Gateelektrode auf der rekristallisierten Zone, die eine Gateelektrode (16) und eine weitere isolierende Schicht (15) umfaßt, die zwischen dieser Gateelektrode und dieser rekristallisierten Zone ausgebildet ist.

10. Herstellungsverfahren nach Anspruch 9,
bei dem die weitere isolierende Schicht (15) eine Siliziumdioxid-Schicht ist, die mittels LPCVD (chemische Dampfabscheidung bei Niederdruck) hergestellt ist.

11. Herstellungsverfahren nach Anspruch 9,
bei dem die Siliziumdiod-Schicht mittels thermischer Oxidation der Oberfläche der rekristallisierten Zone dieser Halbleiterschicht (13) erzeugt ist.

## Revendications

1. Procédé de fabrication d'un dispositif à semiconducteur monocristallin dans une couche semiconductrice polycristalline ou amorphe, comprenant les opérations suivantes :
former une couche semiconductrice amorphe ou polycristalline (13) sur une couche isolante amorphe (12);
former sur ladite couche semiconductrice (13) une pellicule anti-reflet, dépourvue de motif, (14) pour un faisceau lumineux donné;
former sélectivement des ouvertures (123) en des positions prédéterminées de ladite pellicule antireflet (14);
éclairer une zone de la surface de ladite pellicule antireflet (14) avec ledit faisceau lumineux, ladite zone comportant au moins une desdites ouvertures (123), de façon que ladite couche semiconductrice (13) se recristallise et soit ainsi dépourvue de frontières de grain dans ladite ouverture (123), tandis que d'autres parties, restantes, de ladite couche semiconductrice (13) sont laissées dans l'état polycristallin ou amorphe;
former la région active dudit dispositif à semiconducteur dans la couche semiconductrice recristallisée présente dans ladite ouverture (123); et
former des régions de source et de drain (17, 18) dudit dispositif à semiconducteur en appui contre ladite région recristallisée dans lesdites autres parties restantes de ladite couche semiconductrice (13), lesdites régions de source et de drain étant en regard l'une de l'autre de part et d'autre de ladite région recristallisée.

2. Procédé de fabrication d'un dispositif à semiconducteur selon la revendication 1, où ledit semiconducteur est le silicium.

3. Procédé de fabrication d'un dispositif à semiconducteur selon la revendication 2, où ladite couche d'isolation (12) est une couche de dioxyde de silicium.

4. Procédé de fabrication d'un dispositif à semiconducteur selon l'une quelconque des revendications 1 à 3, où ladite pellicule antireflet (14) comprend une couche de nitrure de silicium (122).

5. Procédé de fabrication d'un dispositif à semiconducteur selon la revendication 4, où ladite pellicule antireflet (14) comprend en outre une couche sous-jacente de dioxyde de silicium (121).

6. Procédé de fabrication d'un dispositif à semiconducteur selon l'une quelconque des revendications 1 à 5, où ledit faisceau lumineux est un faisceau laser.

7. Procédé de fabrication d'un dispositif à semiconducteur selon la revendication 6, où ledit faisceau laser est un faisceau laser à argon ionisé.

8. Procédé de fabrication d'un dispositif à semiconducteur selon la revendication 1, où on fait balayer ladite pellicule antireflet (14) par ledit faisceau lumineux de façon que les régions semiconductrices se trouvant au niveau desdites ouvertures (123) soient consécutivement recristallisées.

9. Procédé de fabrication d'un dispositif à semiconducteur selon l'une quelconque des revendications 1 à 8, comprenant en outre l'opération consistant à former une électrode de grille isolée sur ladite région recristallisée comprenant une électrode de grille (16) et une couche isolante supplémentaire (15) formée entre ladite électrode de grille et ladite région recristallisée.

10. Procédé de fabrication d'un dispositif à semiconducteur selon la revendication 9, où ladite couche isolante supplémentaire (15) est une couche de dioxyde de silicium formée par LPCVD (dépôt chimique sous forme vapeur à basse pression).

11. Procédé de fabrication d'un dispositif à semiconducteur selon la revendication 9, où ladite couche isolante supplémentaire (15) est une couche de dioxyde de silicium formée par oxydation thermique de la surface de ladite zone recristallisée de ladite couche semiconductrice (13).
